(19) Europäisches Patentamt
European Patent Office
Office européen des brevets

(11) **EP 2 028 499 B1**

(12) **FASCICULE DE BREVET EUROPEEN**

(45) Date de publication et mention de la délivrance du brevet:
**19.07.2017 Bulletin 2017/29**

(51) Int Cl.:
**G01R 31/02** *(2006.01)*      *G01R 31/08 (2006.01)*
*H02J 13/00 (2006.01)*      *H02H 1/00 (2006.01)*

(21) Numéro de dépôt: **08354032.8**

(22) Date de dépôt: **03.06.2008**

(54) **Contrôle d'isolement d'un ensemble de réseaux électriques interconnectables à neutre isolé**

Kontrolle der Isolierung einer Einheit von Stromnetzen mit isoliertem Nullleiter

Insulation control for interconnectable power grids with insulated neutral

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **21.06.2007 FR 0704427**

(43) Date de publication de la demande:
**25.02.2009 Bulletin 2009/09**

(73) Titulaire: **Schneider Electric Industries SAS**
**92500 Rueil-Malmaison (FR)**

(72) Inventeur: **Vincent, François**
**38050 Grenoble Cedex 09 (FR)**

(74) Mandataire: **Colette, Marie-Françoise et al**
**Schneider Electric Industries SAS**
**Service Propriété Industrielle**
**WTC - E1**
**5, place Robert Schuman**
**38050 Grenoble Cedex 09 (FR)**

(56) Documents cités:
**DE-A1- 10 307 972      FR-A- 2 647 220**
**FR-A- 2 676 821      FR-A- 2 679 039**
**US-A- 5 495 384**

**Description**

**DOMAINE TECHNIQUE**

L'invention concerne le contrôle et la mesure de l'isolement dans une installation de distribution électrique à neutre isolé composée de plusieurs réseaux connectés entre eux par des dispositifs de coupure. L'invention se rapporte plus particulièrement à la gestion des contrôleurs permanents d'isolement, connus sous l'acronyme CPI, en fonction de la connexion des différents éléments de l'ensemble de réseaux.

**ETAT DE LA TECHNIQUE**

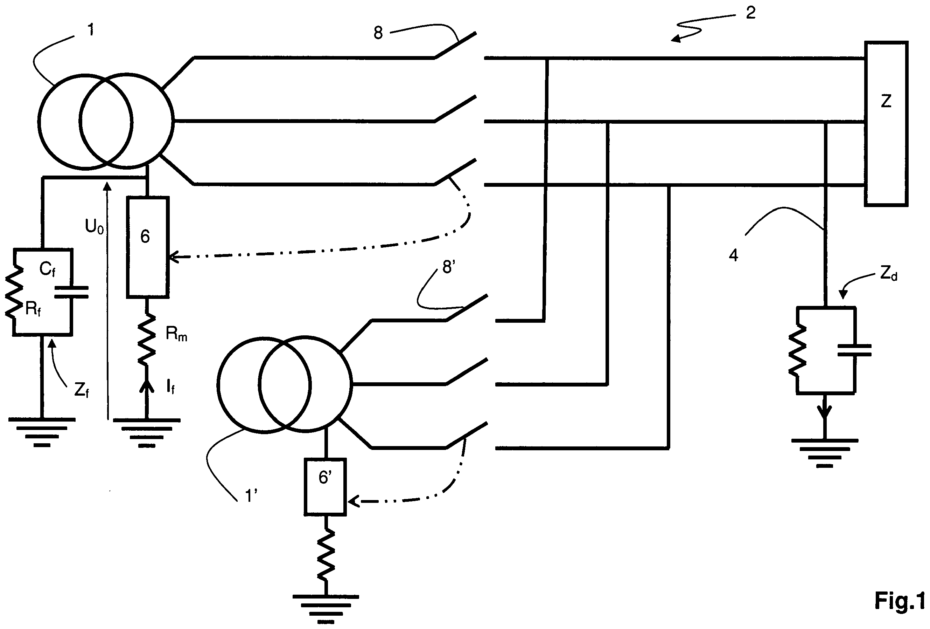

En se référant à la figure 1, un transformateur triphasé 1 alimente en énergie électrique alternative les trois barres de distribution d'un réseau 2 ; le réseau 2 fournit de l'énergie électrique à une impédance de charge Z. Le réseau 2 est dit « à neutre isolé », c'est-à-dire que l'impédance de charge Z est connectée entre une phase et le neutre ou entre phases, mais pas par rapport à la terre.

Il peut survenir que l'impédance de charge présente un défaut d'isolement 4 par rapport à la terre, qui se traduit par la présence dommageable d'une impédance de défaut $Z_d$ entre au moins un des trois fils de phase et la terre. Pour détecter et mesurer la présence de ce type de défaut, un contrôleur permanent d'isolement, ou CPI, 6 est branché en série avec une résistance de mesure $R_m$, par exemple entre le neutre isolé et la terre ; il injecte sur le réseau d'alimentation 2 une tension alternative $U_0$ de fréquence différente et usuellement inférieure à la fréquence propre $F_0$ du courant d'alimentation. En présence du défaut d'isolement 4, l'injection sur le réseau 2 de la tension $U_0$ entraîne la circulation d'un courant de fuite $I_f$, à la fréquence de la tension injectée $U_0$, dans l'impédance de défaut $Z_d$ qui se boucle vers le CPI 6 à travers la terre et la résistance de mesure $R_m$.

De fait, le défaut peut être considéré comme la présence d'une impédance de fuite $Z_f$, usuellement schématisée par un circuit additionnel comprenant une résistance $R_f$ en parallèle avec une capacité $C_f$, au niveau du CPI 6 sur le neutre. Le CPI 6 comprend classiquement des moyens adaptés, par exemple par démodulation synchrone et par détermination des parties réelle et imaginaire des vecteurs représentatifs de la tension injectée $U_0$ et du courant de fuite $I_f$, pour déterminer les valeurs de la résistance $R_f$ et de la capacité $C_f$ de fuite. Un exemple est donné dans le document FR 2 647 220.

Tel que schématisé en figure 1, dans certains modes de réalisation, le réseau 2 est doublé en ce qui concerne son alimentation : un deuxième transformateur triphasé 1' peut alimenter en énergie électrique alternative les trois barres de distribution 2 en cas de défaillance du premier transformateur 1. Dans cette configuration « normal/secours », des dispositifs de coupure 8, 8' sont associés à chaque transformateur 1, 1', afin de les coupler ou non au réseau 2. Pour garantir le fonctionnement du contrôle de l'isolement, il est alors usuel d'associer au transformateur de secours 1' son propre CPI 6', avec injection de courant alternatif et mesure de l'impédance de fuite $Z_f$. Classiquement, tel que présenté par exemple dans le document FR 2 679 039, qui divulgue le préambule de la revendication 1, chaque contrôleur d'isolement 6, 6' est relié fonctionnellement au dispositif de coupure associé 8, 8', par exemple pour l'arrêter lorsque le transformateur 1, 1' n'est pas en service.

Dans certaines autres configurations, l'installation de distribution comprend plusieurs réseaux interconnectés, qui peuvent être mis en oeuvre individuellement ou ensemble. Or, dans le cas où plusieurs réseaux comprenant chacun un transformateur sont connectés (dans un exemple réducteur : si les deux dispositifs de coupure 8, 8' de la figure 1 sont fermés), il faut éviter que plusieurs contrôleurs d'isolement 6, 6' injectent simultanément du courant, ce qui, même s'ils étaient synchronisés pour que leurs injections soient en phase, rendrait toute mesure des courants de fuite erronée. Dans cette configuration, il est possible de prévoir un ensemble de relais associés aux contrôleurs d'isolement pour gérer leur déconnexion éventuelle : cette solution entraîne la réalisation d'un circuit complexe et onéreux. Une autre solution consiste à relier tous les CPI entre eux par des liaisons informatiques permettant à un logiciel de gérer les exclusions en fonction des multiples données relatives au réseau qui lui sont communiquées en temps réel ; cette option décrite dans FR 2 679 039 est elle aussi complexe et coûteuse.

**EXPOSE DE L'INVENTION**

Parmi autres avantages, l'invention vise à pallier des inconvénients des systèmes de gestion des dispositifs de contrôle et/ou mesure d'isolement existants, et en particulier à alléger la mise en oeuvre des procédures d'exclusion par suppression des bus de communication. La solution retenue selon l'invention est un système de gestion décentralisé itératif ; notamment, un algorithme applicable directement sur les éléments du système, sans que la connaissance des différents paramètres du réseau soit nécessaire à chaque étape, a été établi, conjointement à une sélection des réseaux et installations électriques pour lesquels le dispositif de contrôle de l'isolement selon l'invention est adapté. En particulier, le contrôle selon l'invention est réalisé de façon itérative avec transmissions unidirectionnelles binaires, et les réseaux auxquels il s'applique ne sont pas bouclés.

L'invention concerne, sous un de ses aspects, un dispositif de contrôle de l'isolement d'une installation de distribution électrique multi-réseaux, qui peut être mono- ou multiphasée, voire en courant continu. En particulier, l'installation comprend une succession de réseaux reliés entre eux de façon linéaire, sérielle, entre un premier réseau d'extrémité et un dernier réseau d'extrémité, avec un dispositif de coupure, de type interrupteur ou disjoncteur par exemple, entre deux réseaux consécutifs : chaque dispositif de coupure de couplage peut prendre une position fermée de connexion entre les deux réseaux qui l'encadrent ou une position ouverte d'isolement des deux réseaux. Chaque réseau comprend une charge et des moyens pour générer et distribuer un signal électrique, notamment un transformateur, qui peuvent être associés à un dispositif de coupure de génération pouvant prendre une position fermée dans laquelle le transformateur injecte dans le réseau ou ouverte dans laquelle le réseau est isolé de son transformateur ; le signal électrique est de préférence un signal alternatif. Il est possible qu'un des réseaux au moins soit pourvu d'une ou plusieurs dérivations.

Ce type d'installation est muni d'un dispositif de contrôle de l'isolement qui comprend notamment un contrôleur d'isolement pour chacun des réseaux, c'est-à-dire des moyens additionnels pour injecter un signal de courant différent, de préférence alterné de basse fréquence, au niveau des moyens pour générer et distribuer le signal électrique, par exemple sur le neutre. De préférence, la fréquence du courant injecté est un sous-multiple de la fréquence propre du réseau. Un contrôleur d'isolement au moins, et de préférence chacun, comprend des moyens de mesure du courant de fuite à son niveau et des moyens de détermination de l'impédance de fuite globale en fonction de la tension injectée et du courant mesuré, par exemple par démodulation synchrone.

Le dispositif de contrôle peut aussi comprendre, si l'installation présente des dérivations, des moyens de mesure du courant et de la tension de défaut placés sur chaque dérivation à contrôler, et un système de détermination de l'impédance de défaut de ladite dérivation en fonction de la tension et du courant de défaut qui y sont mesurés. La mesure du courant de défaut peut être réalisée par un tore de détection qui entoure entièrement la dérivation, c'est-à-dire ses différents composants de phases et/ou neutre. De préférence, les mesures de la tension et du courant sont simultanées, des moyens d'étalonnage permettant de mesurer le gain et la phase de chacune des chaînes de mesure.

Afin de prendre en compte les interconnexions et d'interdire d'injecter du courant dans l'installation lorsqu'un autre contrôleur d'isolement y est actif, chaque contrôleur d'isolement du dispositif de contrôle selon l'invention comprend un dispositif de gestion des exclusions associé à des moyens pour activer ou non les moyens d'injection du signal de courant alterné. Le dispositif de gestion des exclusions, par exemple par des moyens algorithmiques, détermine l'état d'activation du contrôleur d'isolement en fonction des caractéristiques des différents réseaux le précédant. En particulier, il comprend des moyens pour recevoir des informations relatives à la position du dispositif de coupure de couplage le précédant, des moyens pour recevoir, du dispositif de gestion des exclusions précédent, des informations relatives à l'injection ou non d'un contrôleur d'isolement dans le réseau qui le précède, et, selon la configuration de l'installation, des moyens pour recevoir l'information relative à la position du dispositif de coupure de génération auquel il est associé : ces différentes informations sont utilisées pour gérer l'injection ou non du contrôleur. Par ailleurs, le dispositif de gestion des exclusions transmet au dispositif de gestion des exclusions le suivant une information relative à l'injection dans son réseau d'un quelconque contrôleur. Les différentes informations peuvent être transmises par des liaisons filaires, ou des communications sans fil, qui sont avantageusement adaptées pour une transmission en mode binaire et unidirectionnel.

Sous un autre aspect, l'invention concerne l'installation précitée munie d'un dispositif de contrôle de l'isolement.

## BREVE DESCRIPTION DES FIGURES

D'autres avantages et caractéristiques ressortiront plus clairement de la description qui suit de modes particuliers de réalisation de l'invention, donnés à titre illustratif et nullement limitatifs, représentés dans les figures annexées.

La figure 1, déjà décrite, illustre le fonctionnement d'un contrôleur d'isolement dans un réseau.

La figure 2A représente une installation multi-réseaux comprenant un dispositif de contrôle d'isolement selon un mode de réalisation préféré de l'invention ; la figure 2B en illustre de façon plus détaillée un élément.

La figure 3 montre un algorithme d'exclusion pour un dispositif de contrôle selon l'invention.

## DESCRIPTION DETAILLEE D'UN MODE DE REALISATION PREFERE

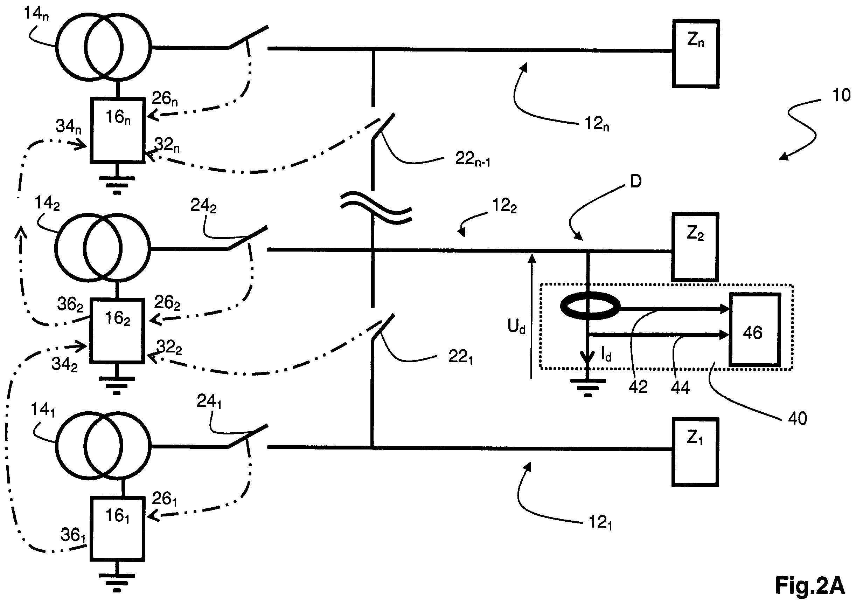

Dans un mode de réalisation préféré de l'invention illustré en figure 2A, une installation de distribution électrique multi-réseaux 10 est composée de plusieurs éléments, ou réseaux individuels, $12_i$ alimentés chacun par des moyens $14_i$ pour générer et injecter un signal électrique, en particulier un transformateur de courant alternatif triphasé de fréquence

propre $F_0$, vers une charge $Z_i$.

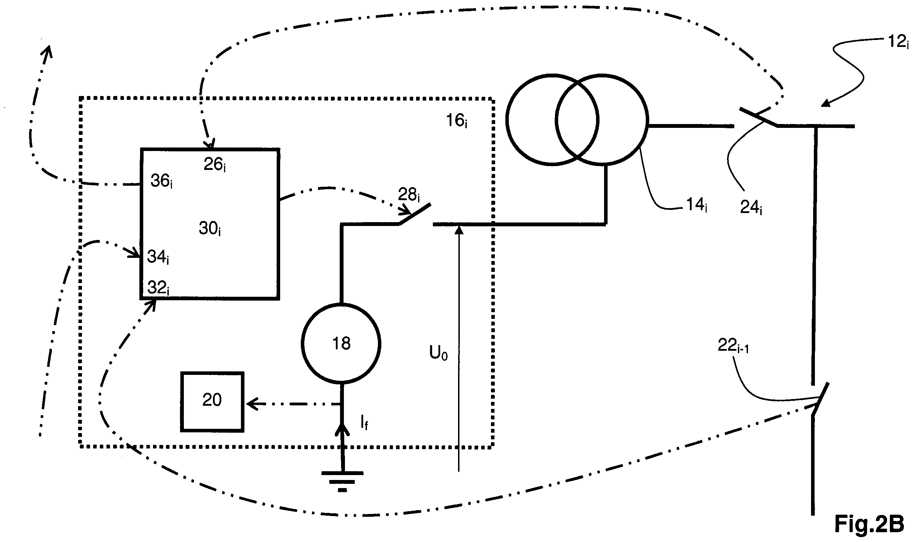

A chaque réseau individuel 12 est associé un CPI 16 qui comprend des moyens 18 pour générer et injecter un signal $U_0$ de courant alternatif d'une première fréquence $f_1$ dans le réseau 12, de préférence au niveau du neutre (figure 2B). Usuellement, et bien que ces éléments ne soient pas indispensables à l'invention, le CPI 16 comprend des moyens connus pour détecter et/ou mesurer l'intensité $I_f$ du courant généré à la première fréquence $f_1$ à son niveau, ainsi que des moyens de détermination, voire de visualisation, 20 de l'impédance de fuite générale $Z_f$ du réseau grâce à la connaissance de la tension injectée $U_0$, par exemple par démodulation synchrone.

Pour un réseau 12 d'alimentation triphasé de fréquence propre $F_0$, avantageusement et afin de simplifier la détection de la réponse et la démodulation synchrone, la première fréquence $f_1$ est un sous-multiple de la fréquence propre $F_0$ dont le choix dépend de compromis entre puissance et détection ; notamment, pour un réseau 12 fonctionnant à $F_0 = 50$ Hz, la première fréquence $f_1$ peut être de 1,25 Hz, 2,5 Hz, 5 Hz ou 10 Hz.

Les différents éléments 12 de l'installation de distribution multi-réseaux 10 selon l'invention sont interconnectés pour former une série linéaire entre un premier réseau d'extrémité $12_1$ et un dernier réseau d'extrémité $12_n$, comprenant éventuellement au moins un réseau intermédiaire $12_i$ relié à un réseau précédent $12_{i-1}$ et à un réseau suivant $12_{i+l}$ ; il est ainsi possible d'attribuer un numéro d'ordre aux différents composants de chaque réseau 12 entre un premier composant $14_1$, $Z_1$, $16_1$ et un composant de deuxième extrémité $14_n$, $Z_n$, $16_n$. Le couplage ou non entre deux réseaux successifs $12_i$, $12_{i+1}$ est réalisé par l'intermédiaire d'un dispositif de coupure $22_i$, par exemple un disjoncteur ou un interrupteur : selon la position des contacts dudit dispositif de coupure de couplage $22_i$, les charges $Z_i$, $Z_{i+1}$ sont connectées en parallèle ou isolées l'une de l'autre.

Dans un mode de réalisation avantageux d'une installation selon l'invention, il est possible de déconnecter chacun des transformateurs 14 des réseaux 12. A cette fin, en amont de l'interconnexion 22 entre réseaux 12, chaque transformateur 14 est associé à un dispositif de coupure 24, par exemple un interrupteur ou un disjoncteur. De préférence, chaque CPI $16_i$ comprend des moyens $26_i$ pour recevoir l'information relative à l'état, ouvert ou fermé, du dispositif de coupure $24_i$ du transformateur $14_i$ auquel il est associé. Le CPI 16 comprend des moyens 28 pour activer ou non ses moyens de génération 18 d'un signal alterné de première fréquence $f_1$, qui peuvent dépendre de l'information concernant le dispositif de coupure de génération 24 reçue par le récepteur 26 : il peut être avantageux que le CPI $16_i$ injecte si le disjoncteur $24_i$ du transformateur est ouvert, c'est-à-dire quand il est isolé de l'installation 10, afin de vérifier l'isolement du transformateur $14_i$ à vide.

Afin de gérer les exclusions, outre la connaissance de son couplage direct avec le(s) réseau(x) 12, chaque CPI 16 doit connaître l'état d'interconnexion des réseaux 12 et l'état d'activation des autres CPI 16. A cette fin, un dispositif de gestion des exclusions 30 est associé aux moyens d'activation 28 afin de lui communiquer l'état à adopter en fonction des informations pertinentes ; le récepteur 26 d'informations relatives au dispositif de coupure de génération 24 peut lui être intégré.

Pour déterminer s'il est le premier ou non d'un ensemble connecté de réseaux $12_i$, chaque CPI $16_i$ est muni de moyens $32_i$ permettant de connaître l'état d'ouverture ou de fermeture du disjoncteur de couplage $22_{i-1}$ entre son réseau $12_i$ et le réseau $12_{i-1}$ qui le précède. En ce qui concerne le premier réseau $12_1$ et/ou CPI $16_1$ d'extrémité, ces moyens $32_1$ ne sont pas nécessaires mais, avantageusement, tous les CPI 16 d'un dispositif selon l'invention sont identiques.

Par ailleurs, chaque CPI $16_i$ comprend des moyens $34_i$ pour recevoir des informations relatives à l'état injecteur ou non du CPI $16_{i-1}$ qui le précède dans la chaîne, et des moyens $36_i$ pour transmettre au CPI $16_{i+1}$ qui le suit dans la chaîne les informations relatives à l'activation ou non d'un contrôleur antérieur ; ici encore, les deux CPI d'extrémité $16_1$, $16_n$ peuvent ne comprendre que les moyens 34, 36 qui leur sont nécessaires en raison de leur position dans la chaîne, mais il est avantageux que tous les CPI 16 soient identiques.

Chaque dispositif de gestion 30 comprend ainsi de préférence trois entrées 26, 32, 34 lui permettant de connaître la position, ouverte ou fermée, des disjoncteurs de couplage 22 et de transformateur 24, ainsi que l'état, injecteur ou non, des CPI qui le précèdent. Suivant ces informations, le dispositif de gestion 30 place ses moyens d'activation 28 en position d'injection ou non, et une sortie 36 lui permet de communiquer au CPI $16_{i+1}$ suivant les informations relatives à l'état d'injection d'un CPI dans l'ensemble de réseaux $12_1$-$12_i$. Les transmissions sont simples : unidirectionnelles, elles concernent des informations binaires. En particulier, des liaisons filaires ou des communications sans fil, ou tout autre moyen, peuvent être adoptés, en fonction des récepteurs 26, 32, 34 ; les moyens de transmission peuvent être identiques ou différents pour un même CPI 16 et/ou une même installation 10.

Le dispositif de gestion des exclusions $30_i$ détermine, par exemple par des moyens algorithmiques, si les moyens d'activation $28_i$ du CPI $16_i$ seront opérationnels ou non : de façon basique, s'il y a un couplage avec une partie de l'installation 10 et s'il y a déjà un CPI qui injecte dans cette partie, il ne faut pas que le CPI injecte sur le réseau.

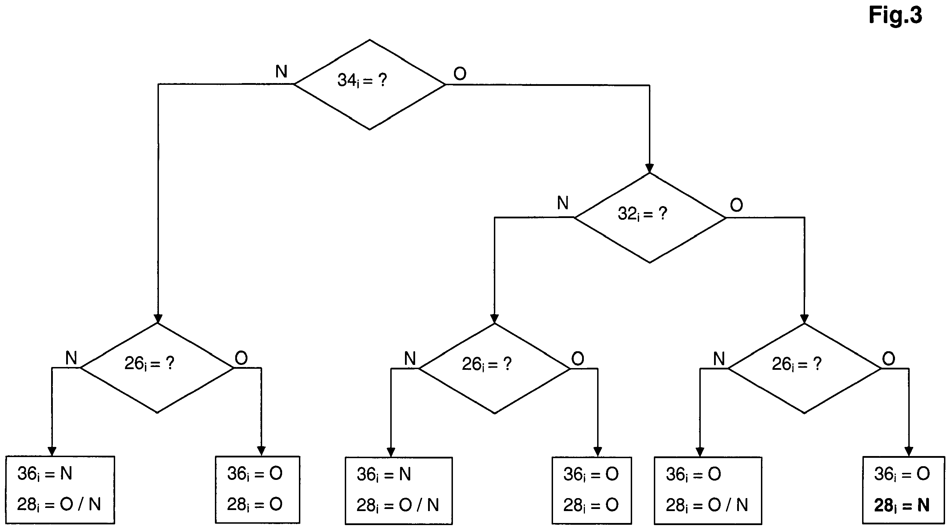

En particulier, et tel que présenté schématiquement en figure 3, si le dispositif de couplage du transformateur $24_i$ est ouvert, les moyens d'activation $28_i$ du CPI $16_i$ peuvent être ouverts ou fermés, car le CPI $16_i$ n'injecte que dans son transformateur $14_i$. Sinon, si le réseau $12_i$ n'est pas couplé au réseau précédent $12_{i-1}$ (disjoncteur de couplage $22_{i-1}$ ouvert, c'est-à-dire $32_i = N$), alors les moyens d'activation $28_i$ sont actifs et le CPI $16_i$ injecte dans le réseau $12_i$. Si le

dispositif de couplage du transformateur $24_i$ est fermé et si, par contre, le réseau $12_i$ est couplé au réseau précédent $12_{i-1}$, alors l'état d'activation $28_i$ dépend des informations relatives aux CPI précédents : si l'information $34_i$ indique qu'un CPI injecte, alors il y a exclusion et le CPI $16_i$ ne doit pas injecter, sinon le CPI $16_i$ injecte dans le réseau $12_i$.

Par ailleurs, le dispositif de gestion $30_i$ envoie une information $36_i$ au CPI $16_{i+1}$ suivant pour permettre à son dispositif de gestion $30_{i+1}$ d'élaborer l'état des moyens d'injection $18_{i+1}$. En particulier :

- Si le CPI $16_{i-1}$ n'injecte pas ($36_{i-1} = N = 34_i$) et si le dispositif de coupure $24_i$ du transformateur $14_i$ est ouvert ($26_i = N$), alors le signal $36_i$ indique qu'il n'y a pas d'injection ($36_i = N$) ; si le dispositif de coupure de génération $24_i$ est fermé ($26_i = O$), alors le signal $36_i$ indique une injection par le CPI $16_i$ ($36_i = O$).
- Si les signaux reçus par le CPI $16_i$ indiquent une injection du CPI précédent $16_{i-1}$ ($34_i = O$) et qu'il y a un couplage $22_{i-1}$ avec le réseau précédent $12_{i-1}$ ($32_i = O$), alors son dispositif de gestion $30_i$ donne une valeur positive quant à l'injection d'un CPI sur l'ensemble de réseaux $12_1$-$12_i$ ($36_i = O$) ; si par contre le réseau $12_i$ est isolé du réseau précédent ($32_i = N$), alors le signal $36_i$ émis dépend de l'état du disjoncteur de générateur $24_i$ et de sa connexion au réseau $12_i$.

Il est ainsi possible de gérer l'exclusion mutuelle des CPI 16 directement par eux-mêmes, quel que soit leur nombre n, tant que l'installation 10 de réseaux multiples 12 n'est pas bouclée, c'est-à-dire qu'il n'y a pas de couplage 22 possible entre deux réseaux non adjacents 12.

Dans cette configuration multi-réseaux 10, il est par ailleurs possible qu'un au moins des réseaux $12_2$ comprenne des dérivations D. Il peut alors être important de localiser et déterminer un défaut détecté au niveau central par un CPI injecteur 16 : la parfaite connaissance du défaut $Z_d$ et de ses caractéristiques résistive $R_d$ et capacitive $C_d$ permet d'adapter sa correction.

Ce type de détection locale a été proposé dans le document FR 2 676 821 où, sur chacune des dérivations d'un réseau simple, avec un unique CPI, sont mis en place des moyens de mesure du courant de défaut local parcourant la dérivation et causé par le signal alternatif injecté dans l'élément de réseau par le CPI. Le signal de mesure est communiqué à des moyens de traitement et calcul, par démodulation ou détection synchrone, et permet, en fonction du signal injecté, de déterminer la valeur de l'impédance locale de fuite ; à cette fin, un signal de synchronisation est envoyé par le CPI vers les moyens de mesure, par l'intermédiaire d'une liaison synchrone adaptée, généralement un bus de communication. La mise en oeuvre de ce type de localisation est cependant lourde. En particulier, dans le cas d'une installation 10 de multiples réseaux 12, il est nécessaire de connaître le CPI injecteur 16 et de synchroniser la mesure locale du courant de fuite avec son signal.

Selon un mode de réalisation préféré de l'invention, contrairement au dispositif décrit dans FR 2 679 039, la dérivation D comprend un dispositif 40 permettant la détermination de l'impédance de défaut $Z_d$ éventuelle à partir de mesures locales de l'intensité $I_d$ et de la tension $U_d$ du courant y circulant, qui résulterait de l'injection par un des CPI 16. A cette fin, sur la dérivation D se trouvent des moyens 42 pour mesurer le courant de défaut $I_d$ à la première fréquence $f_1$, notamment un tore de détection entourant l'ensemble des différents conducteurs (phases et/ou neutre) de la dérivation D associé à un circuit de mesure de type classique ; de plus, des moyens 44 pour mesurer la tension à la première fréquence $f_1$ sont placés sur la dérivation D. Les résultats $I_d$, $U_d$ sont envoyés à un système de traitement 46.

De préférence, pour accélérer la détermination, les mesures du courant et de la tension au niveau de la dérivation sont simultanées et réalisées en parallèle par deux chaînes distinctes 42, 44, comprenant usuellement un filtrage et une amplification. Afin de s'affranchir des paramètres de leurs composants et du déphasage inhérent entre les valeurs de $I_d$ et $U_d$, un étalonnage est préalablement réalisé. A cette fin, par exemple, une impédance d'étalonnage (dont les caractéristiques sont déterminées précisément et stables dans le temps) est mise en place sur la dérivation D et un CPI 16 y injecte la tension $U_0$ afin de mesurer le gain G et la phase P à la première fréquence $f_1$ (de pulsation $\omega_1$) pour les chaînes de mesure 42, 44 ; de préférence, si un tore de mesure est utilisé, ses caractéristiques sont également prises en compte, par exemple grâce à un dispositif de simulation des capteurs de courant (notamment un tore de caractéristiques identiques au tore de mesure). Une fois l'étalonnage terminé, c'est-à-dire que G et P sont quasi-constants et égaux, le déphasage $P_m$ et le gain $G_m$ ainsi déterminés des chaînes de mesure sont utilisés comme paramètres dans les déterminations de $Z_d$ avec $U_d$ et $I_d$, grâce à deux mesures simultanées de la tension et du courant de défaut au niveau de la dérivation D :

$$1/R_d + j \cdot \omega_1 \cdot C_d = (G_m + j \cdot P_m) \cdot (I_dr + j \cdot I_di) / (U_dr + j \cdot U_di) \qquad (1)$$

avec $j^2 = -1$, $I_di$ et $I_dr$ (respectivement $U_di$ et $U_dr$) parties réelle et imaginaire de $I_d$ (respectivement $U_d$).

Grâce à cet étalonnage, une précision de $\pm$ 20 % sur les chaînes de mesure 42, 44 est suffisante, et le bon fonctionnement du produit est en outre vérifié par ce contrôle du gain et de la phase. Il peut être prévu de réaliser des étalonnages automatisés de façon cyclique pour prendre en compte les modifications des chaînes de mesure en fonction de la température.

Pour résoudre l'équation (1) et déterminer $C_d$ et $R_d$, le système de traitement 46 comprend avantageusement des moyens pour déterminer la partie réelle et la partie imaginaire du rapport entre tension $U_d$ et intensité $I_d$ ; de préférence, ces moyens sont adaptés pour faire une démodulation synchrone : à la fin d'une acquisition de mesures, c'est-à-dire après au moins une période $1/f_1$ du signal d'injection, chaque échantillon est multiplié par les fonctions sinus et cosinus pour avoir les parties réelle et imaginaire du signal. Comme les deux mesures de tension et d'intensité concernent la même dérivation D, le référentiel de démodulation synchrone entre $U_d$ et $I_d$ est local, et il n'est pas nécessaire de se rapporter au référentiel utilisé pour le CPI 16, ni même de connaître lequel parmi les différents CPI $16_i$ injecte. La mesure locale conjointe permet ainsi de déterminer l'impédance d'isolement $Z_d$ d'un départ D sans aucune connexion filaire avec un quelconque CPI 16, ni même connaissance de l'origine du courant injecté $U_0$, uniquement par le système de traitement 46 et l'équation (1).

En particulier, le dispositif selon l'invention peut être utilisé conjointement avec le dispositif décrit dans la demande de brevet français FR 07 04426 intitulée *«Dispositif de contrôle et de mesure localisés d'isolement pour réseau électrique à neutre isolé».*

Grâce à la gestion des exclusions selon l'invention, l'architecture et la mise en place des composants de surveillance d'une installation à réseaux interconnectables est allégée, avec suppression possible de nombreuses liaisons et/ou communications, et simplification des transmissions restantes. En particulier, selon différents modes de réalisation préféré, il n'est plus nécessaire, dans la plupart des cas, de décrire ni de sauvegarder la topologie du réseau dans un système de configuration ; l'extension d'un réseau en est donc d'autant simplifiée. Le choix d'une décentralisation complète de la gestion des exclusions, certes limitée aux installations non bouclées de réseaux, associé à l'optimisation d'un processus de gestion permettant une transmission restreinte, unidirectionnelle, et donc « légère », d'informations binaires, permet en outre que le processus soit effectif y compris en l'absence de mesure dans les branches du réseau, quelle que soit la cause de cette absence (défaillance d'un dispositif de mesure, choix économique,...).

Bien que l'invention ait été décrite en référence à une installation triphasée de réseaux sur les neutres desquels sont branchés les contrôleurs permanents d'isolement, elle ne s'y limite pas : la solution proposée peut être appliquée à des alimentations différentes, par exemple de fréquence autre que 50 Hz ou monophasée, et/ou les contrôleurs d'isolement peuvent injecter leur signal sur une phase du réseau et/ou l'injection peut être continue pour des réseaux purement alternatifs. De la même façon, les CPI peuvent fonctionner sur un autre principe que la démodulation synchrone.

## Revendications

1.  Dispositif de contrôle de l'isolement d'une installation (10) de plusieurs réseaux (12) interconnectables qui comprennent chacun des moyens (14) pour générer et distribuer un signal électrique et une charge (Z), ladite installation (10) comprenant un premier réseau d'extrémité $(12_1)$ relié à un dernier réseau d'extrémité $(12_n)$ et éventuellement un ou plusieurs réseaux intermédiaires $(12_i)$ entre les deux réseaux d'extrémité $(12_1, 12_n)$, deux réseaux successifs $(12_i, 12_{i+1})$ étant reliés par l'intermédiaire d'un dispositif de coupure de couplage $(22_i)$ pouvant prendre une position fermée de couplage et une position ouverte d'isolement des deux réseaux $(12_i, 12_{i+1})$,

    ledit dispositif de contrôle comprenant une série de contrôleurs d'isolement $(16_i)$, chaque contrôleur d'isolement (16) étant associé à un réseau (12) et comprenant des moyens (18) pour y injecter un signal de courant alterné au niveau des moyens pour générer et distribuer le signal électrique (14),

    **caractérisé en ce que** chaque contrôleur d'isolement $(16_i)$ comprend un dispositif de gestion des exclusions $(30_i)$ qui comprend :

    - des moyens $(32_i)$ pour recevoir des informations relatives à la position du dispositif de coupure de couplage $(22_{i-1})$ le précédant ;
    - des moyens $(34_i)$ pour recevoir du dispositif de gestion des exclusions précédent $(30_{i-1})$ des informations relatives à l'injection d'un contrôleur d'isolement $(16_{1 \rightarrow i-1})$ dans le réseau $(12_{i-1})$ précédent ;
    - des moyens $(28_i)$ pour activer les moyens d'injection $(18_i)$ dudit contrôleur d'isolement $(16_i)$ en fonction des informations reçues ;
    - des moyens $(36_i)$ pour envoyer au dispositif de gestion des exclusions suivant $(30_{i+1})$ des informations relatives à l'injection d'un contrôleur d'isolement dans son réseau $(12_i)$.

2.  Dispositif selon la revendication 1 pour une installation (10) dans laquelle chacun des moyens $(14_i)$ pour générer et distribuer un signal électrique est associé à un dispositif de coupure de génération $(24_i)$ pouvant prendre une position fermée de distribution dans l'installation (10) et une position ouverte d'isolement par rapport à l'installation (10), dans lequel les dispositifs de gestion des exclusions $(30_i)$ comprennent des moyens $(26_i)$ pour recevoir l'in-



formation relative à la position du dispositif de coupure de génération ($24_i$) auquel ils sont associés et cette information est prise en compte par les moyens ($28_i$) pour activer les moyens d'injection ($18_i$) de leur contrôleur d'isolement ($16_i$).

3. Dispositif selon l'une des revendications 1 ou 2 dans lequel un contrôleur d'isolement au moins comprend des moyens (20) de mesure du courant de fuite ($I_f$) et de détermination de l'impédance de fuite ($Z_f$) globale en fonction de la tension injectée ($U_0$) et du courant ($I_f$) mesuré.

4. Dispositif selon l'une des revendications 1 à 3 dans lequel les informations ($24_i$, $32_i$, $34_i$, $36_i$) des dispositifs de gestion des exclusions ($30_i$) sont transmises par des liaisons filaires.

5. Dispositif selon l'une des revendications 1 à 4 pour une installation dans laquelle un des réseaux au moins ($12_2$) comprend une dérivation (D), ledit dispositif comprenant en outre :

   - des moyens (42) de mesure du courant de défaut ($I_d$) pour être placés sur la dérivation (D) ;
   - des moyens (44) de mesure de la tension de défaut ($U_d$) pour être placés sur la dérivation (D);
   - un système (46) de détermination de l'impédance de défaut ($Z_d$) de la dérivation (D) en fonction de la tension ($U_d$) et du courant ($I_d$) mesurés sur ladite dérivation.

6. Dispositif selon la revendication 5 dans lequel les moyens (42) de mesure du courant de défaut ($I_d$) comprennent un tore de détection entourant l'ensemble des conducteurs de la dérivation (D).

7. Dispositif selon l'une des revendications 5 ou 6 dans lequel les moyens (42) de mesure du courant de défaut ($I_d$) et les moyens (44) de mesure de la tension de défaut ($U_d$) d'une dérivation (D) sont adaptés pour mesurer le courant et la tension de défaut ($I_d$, $U_d$) simultanément.

8. Dispositif selon la revendication 7 comprenant en outre des moyens d'étalonnage pour mesurer le gain et la phase des moyens de mesure (42, 44).

9. Installation de distribution électrique (10) comprenant des réseaux interconnectables (12) entre un premier réseau d'extrémité ($12_1$) et un dernier réseau d'extrémité ($12_n$), avec éventuellement au moins un réseau intermédiaire ($12_i$) entre les deux réseaux d'extrémité ($12_1$, $12_n$), chaque réseau (12) comprenant des moyens (14) pour générer et distribuer un signal électrique et une charge (Z), dans laquelle deux réseaux successifs ($12_i$, $12_{i+1}$) sont reliés par l'intermédiaire d'un dispositif de coupure de couplage ($22_i$) pouvant prendre une première position fermée de connexion et une position ouverte d'isolement des deux réseaux ($12_i$, $12_{i+1}$), ladite installation (10) comprenant un dispositif de contrôle de l'isolement selon l'une des revendications 1 à 8.

10. Installation de distribution électrique (10) comprenant des réseaux interconnectables (12) entre un premier réseau d'extrémité ($12_1$) et un dernier réseau d'extrémité ($12_n$), avec éventuellement au moins un réseau intermédiaire ($12_i$) entre les deux réseaux d'extrémité ($12_1$, $12_n$), chaque réseau (12) comprenant des moyens (14) pour générer et distribuer un signal électrique et une charge (Z) et un des réseaux ($12_2$) au moins étant muni d'une dérivation (D) au moins, dans laquelle deux réseaux successifs ($12_i$, $12_{i+1}$) sont reliés par l'intermédiaire d'un dispositif de coupure de couplage ($22_i$) pouvant prendre une première position fermée de connexion et une position ouverte d'isolement des deux réseaux ($12_i$, $12_{i+1}$), ladite installation (10) comprenant un dispositif de contrôle de l'isolement selon l'une des revendications 5 à 8.

11. Installation selon l'une des revendications 9 ou 10 dans lequel les moyens (14) pour générer et distribuer un signal électrique de chaque réseau (12) sont adaptés pour générer et injecter un signal alternatif de fréquence propre ($F_0$).

12. Installation selon la revendication 11 dans lequel les moyens d'injection (18) de chaque contrôleur d'isolement (16) sont adaptés pour injecter sur le neutre du réseau (12) un signal alterné d'une fréquence ($f_1$) qui est un sous-multiple de la fréquence propre ($F_0$).

13. Installation selon l'une des revendications 9 à 12 dans laquelle chacun des moyens ($14_i$) pour générer et distribuer un signal électrique est associé à un dispositif de coupure de génération ($24_i$) pouvant prendre une position fermée de distribution dans l'installation (10) et une position ouverte d'isolement par rapport à l'installation (10).

**Patentansprüche**

1.  Vorrichtung zur Prüfung der Isolation einer Anlage (10) aus mehreren miteinander verbindbaren Netzwerken (12), die je Einrichtungen (14) zur Erzeugung und Verteilung eines elektrischen Signals und eine Last (Z) enthalten, wobei die Anlage (10) ein erstes Endnetzwerk ($12_1$) verbunden mit einem letzten Endnetzwerk ($12_n$) und ggf. ein oder mehrere Zwischennetzwerke ($12_i$) zwischen den zwei Endnetzwerken ($12_1$, $12_n$) enthält, wobei zwei aufeinanderfolgende Netzwerke ($12_i$, $12_{i+1}$) mittels einer Kopplungsunterbrechungsvorrichtung ($22_i$) verbunden sind, die eine geschlossene Kopplungsstellung und eine offene Isolationsstellung der zwei Netzwerke ($12_i$, $12_{i+1}$) einnehmen kann, wobei die Prüfvorrichtung eine Reihe von Isolationsprüfern ($16_i$) enthält, wobei jeder Isolationsprüfer (16) einem Netzwerk (12) zugeordnet ist und Einrichtungen (18) enthält, um ein Wechselstromsignal im Bereich der Einrichtungen (14) zur Erzeugung und Verteilung des elektrischen Signals in dieses einzuspeisen, **dadurch gekennzeichnet, dass** jeder Isolationsprüfer ($16_i$) eine Verwaltungsvorrichtung der Ausschlüsse ($30_i$) enthält, die enthält:

    - Einrichtungen ($32_i$) zum Empfang von Informationen bezüglich der Stellung der ihr vorhergehenden Kopplungsunterbrechungsvorrichtung ($22_{i-1}$);
    - Einrichtungen ($34_i$) zum Empfang von der vorhergehenden Verwaltungsvorrichtung der Ausschlüsse ($30_{i-1}$) von Informationen bezüglich der Einspeisung eines Isolationsprüfers ($16_{1\to i-1}$) in das vorhergehenden Netzwerk ($12_{i-1}$);
    - Einrichtungen (28j) zur Aktivierung der Einspeiseeinrichtungen ($18_i$) des Isolationsprüfers ($16_i$) abhängig von den empfangenen Informationen;
    - Einrichtungen ($36_i$) zum Senden an die folgende Verwaltungsvorrichtung der Ausschlüsse ($30_{i+1}$) von Informationen bezüglich der Einspeisung eines Isolationsprüfers in sein Netzwerk ($12_i$).

2.  Vorrichtung nach Anspruch 1 für eine Anlage (10), bei der jede der Einrichtungen ($14_i$) zur Erzeugung und Verteilung eines elektrischen Signals einer Erzeugungsunterbrechungsvorrichtung ($24_i$) zugeordnet ist, die eine geschlossene Stellung der Verteilung in die Anlage (10) und eine offene Isolationsstellung bezüglich der Anlage (10) einnehmen kann, wobei die Verwaltungsvorrichtungen der Ausschlüsse ($30_i$) Einrichtungen ($26_i$) enthalten, um die Information bezüglich der Stellung der Erzeugungsunterbrechungsvorrichtung ($24_i$) zu empfangen, der sie zugeordnet sind, und diese Information von den Einrichtungen ($28_i$) berücksichtigt wird, um die Einspeiseeinrichtungen ($18_i$) ihres Isolationsprüfers (16j) zu aktivieren.

3.  Vorrichtung nach einem der Ansprüche 1 oder 2, wobei mindestens ein Isolationsprüfer Einrichtungen (20) zur Messung des Streustroms ($I_{fo}$) und zur Bestimmung der globalen Streuimpedanz ($Z_{FM}$) abhängig von der eingespeisten Spannung ($U_0$) und vom gemessenen Strom ($I_{fo}$) enthält.

4.  Vorrichtung nach einem der Ansprüche 1 bis 3, wobei die Informationen ($24_i$, $32_i$, $34_i$, $36_i$) der Verwaltungsvorrichtungen der Ausschlüsse ($30_i$) über drahtgebundene Verbindungen übertragen werden.

5.  Vorrichtung nach einem der Ansprüche 1 bis 4 für eine Anlage, bei der mindestens eines der Netzwerke ($12_2$) eine Abzweigung (D) enthält, wobei die Vorrichtung außerdem enthält:

    - Einrichtungen (42) zur Messung des Fehlerstroms ($I_{da}$), um auf der Abzweigung (D) angeordnet zu werden;
    - Einrichtungen (44) zur Messung der Fehlerspannung ($U_d$), um auf der Abzweigung (D) angeordnet zu werden;
    - ein System (46) zur Bestimmung der Fehlerimpedanz ($Z_u$) der Abzweigung (D) abhängig von der Spannung ($U_d$) und vom Strom ($I_{da}$), die auf der Abzweigung gemessen werden.

6.  Vorrichtung nach Anspruch 5, wobei die Einrichtungen (42) zur Messung des Fehlerstroms ($I_{da}$) einen Erfassungstorus enthalten, der die Gesamtheit der Leiter der Abzweigung (D) umgibt.

7.  Vorrichtung nach einem der Ansprüche 5 oder 6, wobei die Einrichtungen (42) zur Messung des Fehlerstroms ($I_{da}$) und die Einrichtungen (44) zur Messung der Fehlerspannung ($U_d$) einer Abzweigung (D) geeignet sind, den Fehlerstrom und die Fehlerspannung ($I_{da}$, $U_d$) gleichzeitig zu messen.

8.  Vorrichtung nach Anspruch 7, die außerdem Kalibriereinrichtungen enthält, um die Verstärkung und die Phase der Messeinrichtungen (42, 44) zu messen.

9.  Anlage zur Stromverteilung (10), die miteinander verbindbare Netzwerke (12) zwischen einem ersten Endnetzwerk

($12_1$) und einem letzten Endnetzwerk ($12_n$) mit ggf. mindestens einem Zwischennetzwerk ($12_i$) zwischen den zwei Endnetzwerken ($12_1$, $12_n$) enthält, wobei jedes Netzwerk (12) Einrichtungen (14) zur Erzeugung und Verteilung eines elektrischen Signals und eine Last (Z) enthält, wobei zwei aufeinanderfolgende Netzwerke ($12_i$, $12_{i+1}$) mittels einer Kopplungsunterbrechungsvorrichtung ($22_i$) verbunden sind, die eine erste geschlossene Verbindungsstellung und eine offene Isolationsstellung der zwei Netzwerke ($12_i$, $12_{i+1}$) einnehmen kann, wobei die Anlage (10) eine Isolationsprüfvorrichtung nach einem der Ansprüche 1 bis 8 enthält.

10. Anlage zur Stromverteilung (10), die miteinander verbindbare Netzwerke (12) zwischen einem ersten Endnetzwerk ($12_1$) und einem letzten Endnetzwerk ($12_n$) mit ggf. mindestens einem Zwischennetzwerk ($12_i$) zwischen den zwei Endnetzwerken ($12_1$, $12_n$) enthält, wobei jedes Netzwerk (12) Einrichtungen (14) zur Erzeugung und Verteilung eines elektrischen Signals und eine Last (Z) enthält, und mindestens eines der Netzwerke ($12_2$) mit mindestens einer Abzweigung (D) versehen ist, wobei zwei aufeinanderfolgende Netzwerke ($12_i$, $12_{i+1}$) mittels einer Kopplungs-unterbrechungsvorrichtung ($22_i$) verbunden sind, die eine erste geschlossene Verbindungsstellung und eine offene Isolationsstellung der zwei Netzwerke ($12_i$, $12_{i+1}$) einnehmen kann, wobei die Anlage (10) eine Isolationsprüfvorrichtung nach einem der Ansprüche 5 bis 8 enthält.

11. Anlage nach einem der Ansprüche 9 oder 10, wobei die Einrichtungen (14) zur Erzeugung und Verteilung eines elektrischen Signals jedes Netzwerks (12) geeignet sind, ein Wechselstromsignal mit Eigenfrequenz ($F_0$) zu erzeugen und einzuspeisen.

12. Anlage nach Anspruch 11, wobei die Einspeiseeinrichtungen (18) jedes Isolationsprüfers (16) geeignet sind, in den Nullleiter des Netzwerks (12) ein Wechselstromsignal einer Frequenz ($f_1$) einzuspeisen, die ein Untervielfaches der Eigenfrequenz ($F_0$) ist.

13. Anlage nach einem der Ansprüche 9 bis 12, wobei jede der Einrichtungen ($14_i$) zur Erzeugung und Verteilung eines elektrischen Signals einer Erzeugungsunterbrechungsvorrichtung ($24_i$) zugeordnet ist, die eine geschlossene Verteilungsstellung in der Anlage (10) und eine offene Isolationsstellung bezüglich der Anlage (10) einnehmen kann.

## Claims

1. Device for monitoring the isolation of an installation (10) of a plurality of interconnectable networks (12) each comprising means (14) for generating and distributing an electric signal and a load (Z), said installation (10) comprising a first end network ($12_1$) connected to a last end network ($12_n$) and optionally one or more intermediate networks ($12_i$) between the two end networks ($12_1$, $12_n$), two successive networks ($12_i$, $12_{i+1}$) being connected by means of a coupling breaking device ($22_i$) able to adopt a closed position for coupling and an open position for isolating the two networks ($12_i$, $12_{i+1}$),
said monitoring device comprising a series of isolation monitors ($16_i$), each isolation monitor (16) being associated with a network (12) and comprising means (18) for injecting an alternating current signal into the latter at the means for generating and distributing the electric signal (14),
**characterized in that** each isolation monitor ($16_i$) comprises an exclusions management device ($30_i$) that comprises:

- means ($32_i$) for receiving information relating to the position of the coupling breaking device ($22_{i-1}$) preceding it;
- means ($34_i$) for receiving, from the preceding exclusions management device ($30_{i-1}$), information relating to the injection of an isolation monitor ($16_{1 \to i-1}$) into the preceding network ($12_{i-1}$);
- means ($28_i$) for activating the injection means ($18_i$) of said isolation monitor ($16_i$) as a function of the information received;
- means ($36_i$) for sending, to the following exclusions management device ($30_{i+1}$), information relating to the injection of an isolation monitor into its network ($12_i$).

2. Device according to Claim 1 for an installation (10) wherein each of the means ($14_i$) for generating and distributing an electric signal is associated with a generation breaking device ($24_i$) able to adopt a closed distribution position in the installation (10) and an open isolation position with respect to the installation (10), wherein the exclusions management devices ($30_i$) comprise means ($26_i$) for receiving the information relating to the position of the generation breaking device ($24_i$) with which they are associated, and this information is taken into account by the means ($28_i$) for activating the injection means ($18_i$) of their isolation monitor ($16_i$).

3. Device according to either of Claims 1 and 2, wherein at least one isolation monitor comprises means (20) for measuring the leakage current ($I_f$) and for determining the overall leakage impedance ($Z_f$) as a function of the injected voltage ($U_0$) and of the measured current ($I_f$).

4. Device according to one of Claims 1 to 3, wherein the information ($24_i$, $32_i$, $34_i$, $36_i$) from the exclusions management devices ($30_i$) is transmitted by wired links.

5. Device according to one of Claims 1 to 4 for an installation wherein at least one of the networks ($12_2$) comprises a shunt (D), said device furthermore comprising:

   - means (42) for measuring the fault current ($I_d$), to be placed across the shunt (D);
   - means (44) for measuring the fault voltage ($U_d$), to be placed across the shunt (D);
   - a system (46) for determining the fault impedance ($Z_d$) of the shunt (D) as a function of the voltage ($U_d$) and of the current ($I_d$) measured across said shunt.

6. Device according to Claim 5, wherein the means (42) for measuring the fault current ($I_d$) comprise a detection toroid surrounding all of the conductors of the shunt (D).

7. Device according to either of Claims 5 and 6, wherein the means (42) for measuring the fault current ($I_d$) and the means (44) for measuring the fault voltage ($U_d$) of a shunt (D) are designed to measure the fault current and the fault voltage ($I_d$, $U_d$) simultaneously.

8. Device according to Claim 7, furthermore comprising calibration means for measuring the gain and the phase of the measuring means (42, 44).

9. Electricity distribution installation (10) comprising interconnectable networks (12) between a first end network ($12_1$) and a last end network ($12_n$), with optionally at least one intermediate network ($12_i$) between the two end networks ($12_1$, $12_n$), each network (12) comprising means (14) for generating and distributing an electric signal and a load (Z), wherein two successive networks ($12_i$, $12_{i+1}$) are connected by means of a coupling breaking device ($22_i$) able to adopt a first closed position for connecting and an open position for isolating the two networks ($12_i$, $12_{i+1}$), said installation (10) comprising an isolation monitoring device according to one of Claims 1 to 8.

10. Electricity distribution installation (10) comprising interconnectable networks (12) between a first end network ($12_1$) and a last end network ($12_n$), with optionally at least one intermediate network ($12_i$) between the two end networks ($12_1$, $12_n$), each network (12) comprising means (14) for generating and distributing an electric signal and a load (Z), and at least one of the networks ($12_2$) being provided with at least one shunt (D), wherein two successive networks ($12_i$, $12_{i+1}$) are connected by means of a coupling breaking device ($22_i$) able to adopt a first closed position for connecting and an open position for isolating the two networks ($12_i$, $12_{i+1}$), said installation (10) comprising an isolation monitoring device according to one of Claims 5 to 8.

11. Installation according to either of Claims 9 and 10, wherein the means (14) for generating and distributing an electric signal of each network (12) are designed to generate and inject an alternating signal having a natural frequency ($F_0$).

12. Installation according to Claim 11, wherein the injection means (18) of each isolation monitor (16) are designed to inject, on the neutral of the network (12), an alternating signal having a frequency ($f_1$) that is a submultiple of the natural frequency ($F_0$).

13. Installation according to one of Claims 9 to 12, wherein each of the means ($14_i$) for generating and distributing an electric signal is associated with a generation breaking device ($24_i$) able to adopt a closed distribution position in the installation (10) and an open isolation position with respect to the installation (10).

Fig.1

Fig.2A

Fig.2B

Fig.3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2647220
- FR 2679039
- FR 2676821
- FR 0704426